# EUROPEAN PATENT APPLICATION

(11) **EP 4 462 550 A1**
(43) Date of publication of application: **13.11.2024**
(21) Application number: 23847024.9
(22) Date of filing: 27.07.2023
(51) Int. Cl.: H01M 10/48, H01M 10/42, H01M 50/284, H01M 50/242, G01K 7/22, H05K 3/32, C09J 9/02, H01M 50/213

(54) **BATTERY CELL ASSEMBLY INCLUDING THERMISTOR AND MANUFACTURING METHOD THEREFOR**

(30) Priority: 27.07.2022 KR 20220092983
(71) Applicant: LG Energy Solution, Ltd., Seoul 07335 (KR)
(72) Inventor: JEON, Ji Hye, Daejeon 34122 (KR)
(74) Representative: Plasseraud IP
(86) International application number: PCT/KR2023/010946
(87) International publication number: WO 2024/025367

(57) **Abstract**

The present invention relates to a battery cell assembly including a cylindrical battery cell, a PCB disposed on the top of the cylindrical battery cell, and a thermistor configured to measure the temperature of the cylindrical battery cell, wherein the thermistor is disposed at an outer periphery of one side of the PCB, and a method of manufacturing the same.

## Description

### [Technical Field]

This application claims the benefit of priority to Korean Patent Application No. 10-2022-0092983 filed on July 27, 2022, the disclosure of which is incorporated herein by reference in its entirety.

The present invention relates to a battery cell assembly including a thermistor and a method of manufacturing the same. More particularly, the present invention relates to a battery cell assembly including a thermistor capable of accurately measuring the temperature of a battery cell, thereby securing safety thereof, and a method of manufacturing the same.

### [Background Art]

Improvement in stability and increase in capacity of a lithium secondary battery, which is capable of being charged and discharged, have been rapidly achieved, and kinds of devices that use the lithium secondary battery as an energy source have been increased.

For example, the lithium secondary battery has been widely used as an energy source for wireless mobile devices, which are small multifunctional products, or wearable devices, which are worn on the body, and has also been used as a medium or large battery pack for use as an energy source for electric vehicles and hybrid electric vehicles presented as alternatives to existing gasoline and diesel vehicles, which cause air pollution, or as an energy storage system (ESS).

Depending on the shape of a battery case, the lithium secondary battery is classified as a cylindrical secondary battery, configured to have a structure in which an electrode assembly is mounted in a cylindrical metal can, a prismatic secondary battery, configured to have a structure in which an electrode assembly is mounted in a prismatic metal can, or a pouch-shaped secondary battery, configured to have a structure in which an electrode assembly is mounted in a pouch-shaped case made of an aluminum laminate sheet. Thereamong, the cylindrical secondary battery has advantages of a relatively large capacity and structural safety.

Overheating of a battery cell may shorten the lifespan of the battery cell, and if the battery cell explodes due to thermal runaway in the battery cell, a device having the battery cell mounted therein may be affected.

Therefore, it is important to manage the temperature of the battery cell.

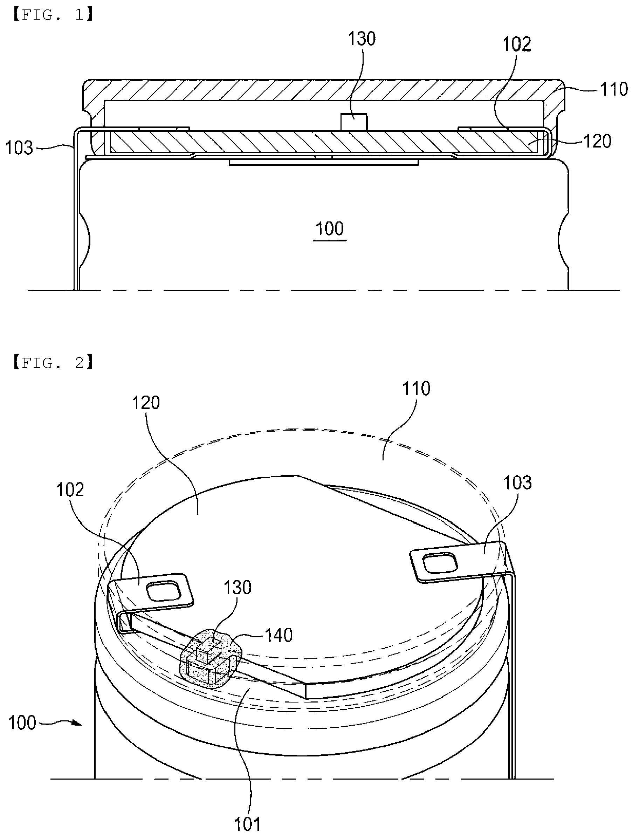

FIG. 1 is a vertical sectional view of a conventional battery cell assembly.

Referring to FIG. 1, the battery cell assembly is configured such that a PCB 120 is located on the top of a cylindrical battery cell 100, a positive electrode terminal of the cylindrical battery cell and a terminal of the PCB 120 are connected to each other via a first metal plate 102, and a negative electrode terminal of the cylindrical battery cell and another terminal of the PCB 130 are connected to each other via a second metal plate 103.

A thermistor 130 configured to measure the temperature of the cylindrical battery cell is located at a central part of the PCB on an upper surface of the PCB 120. If the thermistor is disposed in this manner, however, the thermistor 130 and the battery cell 100 are not in contact with each other, whereby the thermistor 130 measures the temperature of the air, and therefore it is difficult to accurately measure the temperature of the battery cell 100.

In Patent Document 1, electrode terminals protrude from an outer periphery of one side of a pouch-shaped battery cell, and the electrode terminals are coupled to a connection terminal of a protective circuit board disposed at an upper end of the pouch-shaped battery cell. A thermistor configured to detect the temperature of the outer surface of the battery cell is attached to an end portion of the protection circuit board adjacent to the sealed outer periphery of the battery cell from which the electrode terminals protrude, and a thermally conductive tape configured to physically connect the battery cell and the thermistor to each other is attached to the outer surface of the battery cell and an outer surface of the thermistor. Consequently, heat from the battery cell is conducted to the thermistor via the thermally conductive tape.

Patent Document 2 discloses a sensing module disposed on the top of a cell stack constituted a plurality of battery cells disposed in an interior space of a module housing, wherein the sensing module has a temperature sensor configured to measure the temperature of each of the battery cells.

As described above, Patent Document 1 is a technology for measuring the temperature of the pouch-shaped battery cell, and Patent Document 2 is a technology for disposing the sensing module having the temperature sensors provided in the battery module housing; however, these patent documents do not suggest a configuration in which, when a PCB is located on the top of a cylindrical battery cell, a thermistor disposed on the PCB directly or indirectly measures the temperature of the cylindrical battery cell.

### (Prior Art Documents)

(Patent Document 1) Korean Patent Application Publication No. 2017-0023466 (2017.03.06)
(Patent Document 2) Korean Patent Application Publication No. 2022-0030544 (2022.03.11)

### [Disclosure]

### [Technical Problem]

The present invention has been made in view of the above problems, and it is an object of the present invention to provide a battery cell assembly including a thermistor configured such that heat of a battery cell is transferred to the thermistor via a thermally conductive adhesive added to the thermistor, whereby the temperature of the battery cell is accurately measured, and a method of manufacturing the same.

### [Technical Solution]

A battery cell assembly according to the present invention to accomplish the above object includes a cylindrical battery cell, a PCB disposed on the top of the cylindrical battery cell, and a thermistor configured to measure a temperature of the cylindrical battery cell, wherein the thermistor is disposed at an outer periphery of one side of the PCB.

The PCB may include a protrusion protruding from the outer periphery of the one side of the PCB, and the thermistor may be disposed on the protrusion.

A thermally conductive adhesive may be added to the thermistor, the PCB having the thermistor mounted thereon, and an upper surface of the cylindrical battery cell.

The thermistor may be in indirect contact with the cylindrical battery cell via the thermally conductive adhesive.

The thermally conductive adhesive may be a mixture of a metal powder and one substance selected from the group consisting of a silicone adhesive, an epoxy adhesive, and an acrylic-based adhesive.

The battery cell assembly may further include a protective case configured to allow the PCB and the thermistor to be disposed in an interior space of the protective case.

The battery cell assembly may further include a first metal plate configured to connect a positive electrode terminal of the cylindrical battery cell to the PCB and a second metal plate configured to connect a negative electrode terminal of the cylindrical battery cell to the PCB.

The thermistor may be a chip-type thermistor.

The PCB may be configured to have a structure in which one side of a planar circular shape is cut, a protrusion is formed at an outer periphery of the cut side so as to protrude outwards from the planar circular shape, and the thermistor is disposed on the protrusion.

The PCB may be configured to have a structure in which a pair of slits parallel to each other are formed in a planar circular shape so as to extend in a direction from an outer periphery of the planar circular shape to the center thereof and the thermistor is disposed between the pair of slits.

The present invention provides a method of manufacturing the battery cell assembly, the method including preparing a cylindrical battery cell and disposing a PCB on the top of the cylindrical battery cell, connecting a positive electrode terminal and a negative electrode terminal of the cylindrical battery cell to the PCB, mounting a thermistor on an outer periphery of one side of the PCB, and adding a thermally conductive adhesive to the thermistor, the PCB having the thermistor mounted thereon, and an upper surface of the cylindrical battery cell.

The method may further include mounting a protective case configured to protect the thermistor and the PCB to the top of the cylindrical battery cell.

The present invention provides a device including the battery cell assembly as an energy source.

In addition, the present invention may provide various combinations of the above constructions.

### [Advantageous Effects]

As is apparent from the above description, in a battery cell assembly according to the present invention, the temperature of a cylindrical battery cell is transferred to a thermistor via a thermally conductive adhesive, whereby it is possible to accurately measure the temperature of the cylindrical battery cell.

In addition, it is possible to rapidly and accurately check the state of the cylindrical battery cell, and therefore it is possible to provide a battery cell assembly with improved safety.

### [Description of Drawings]

FIG. 1 is a vertical sectional view of a conventional battery cell assembly.
FIG. 2 is a see-through perspective view of a battery cell assembly according to the present invention.
FIG. 3 is a vertical sectional view of FIG. 2.
FIG. 4 is a plan view showing embodiments of a PCB according to the present invention.
FIG. 5 is a graph showing the deviation between the temperature of a thermistor and the temperature of a cylindrical battery cell during a charging process in Comparative Example and Example.
FIG. 6 is a graph showing the deviation between the temperature of the thermistor and the temperature of the cylindrical battery cell during a discharging process in Comparative Example and Example.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

In addition, a description to embody elements through limitation or addition may be applied to all inventions, unless particularly restricted, and does not limit a specific invention.

Also, in the description of the invention and the claims of the present application, singular forms are intended to include plural forms unless mentioned otherwise.

Also, in the description of the invention and the claims of the present application, "or" includes "and" unless mentioned otherwise. Therefore, "including A or B" means three cases, namely, the case including A, the case including B, and the case including A and B.

Hereinafter, embodiments of the present invention will be described in detail with reference to the drawings.

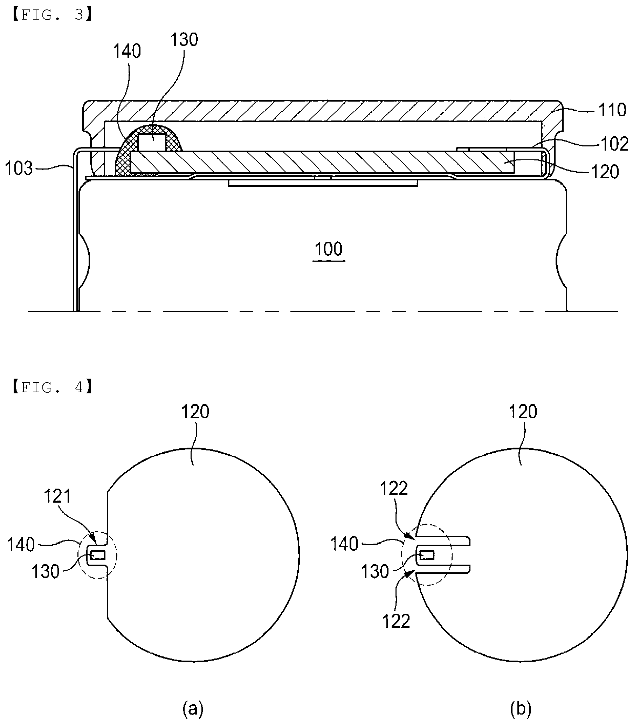

FIG. 2 is a see-through perspective view of a battery cell assembly according to the present invention, and FIG. 3 is a vertical sectional view of FIG. 2.

Referring to FIGs. 2 and 3, the battery cell assembly according to the present invention may include a cylindrical battery cell 100, a PCB 120 disposed on the top of the cylindrical battery cell 100, and a thermistor 130 configured to measure the temperature of the cylindrical battery cell 100, wherein the thermistor 130 may be disposed at an outer periphery of one side of the PCB 120.

Since the thermistor 130 has an electrical property in which the resistance of the thermistor varies depending on the temperature of the cylindrical battery cell, the temperature of the cylindrical battery cell 100 may be estimated through a resistance value of the thermistor 130. The PCB 120 is a component configured to measure the voltage and temperature of the cylindrical battery cell 100, and the temperature of the cylindrical battery cell 100 may be measured by the resistance value obtained through the thermistor 130.

The PCB 120 includes a positive electrode terminal portion and a negative electrode terminal portion, wherein the positive electrode terminal portion is connected to a top cap, which is a positive electrode terminal of the cylindrical battery cell 100, via a first metal plate 102, and the negative electrode terminal portion is connected to the bottom of a cylindrical can, which is a negative electrode terminal of the cylindrical battery cell 100, via a second metal plate 103.

The present invention may be configured such that the thermistor 130 is disposed at an outer periphery of one side of the PCB 120 and a thermally conductive adhesive 140 is added to the thermistor 130, whereby heat conduction may occur between the thermistor 130 and the cylindrical battery cell 100 via the thermally conductive adhesive 140.

To this end, the PCB 120 may include a protrusion protruding from an outer periphery of one side thereof, and the thermistor 130 may be mounted on the protrusion so as to be attached thereto.

At this time, the thermally conductive adhesive 140 may be added to the thermistor 130, the PCB 120 having the thermistor mounted thereon, and an upper surface 101 of the cylindrical battery cell.

That is, when a predetermined amount of thermally conductive adhesive 140 is added to the thermistor 130 mounted on the PCB 120, such that the thermally conductive adhesive 140 comes into contact with even the upper surface 101 of the cylindrical battery cell, the thermistor 130 may be in indirect contact with the cylindrical battery cell 100 via the thermally conductive adhesive 140.

Consequently, heat transfer is achieved from the cylindrical battery cell 100 to the thermistor 130 via the thermally conductive adhesive 140, and therefore the thermistor 130 may accurately measure the temperature of the cylindrical battery cell 100.

The thermally conductive adhesive may be a mixture of metal powder and any one selected from the group consisting of a silicone adhesive, an epoxy adhesive, and an acrylic-based adhesive.

The metal powder may be a metal that exhibits excellent thermal conductivity in powder form, and may include, for example, aluminum, copper, gold, silver, tungsten, zinc, brass, nickel, bronze, carbon steel, or a mixture thereof.

The thermistor 130 may be used in a state of being mounted on the upper surface of the PCB 120, and a chip-type thermistor may be used. Conventionally, a wire-type thermistor or an FPCB-type thermistor is used to measure the temperature of a top plate of a cylindrical battery cell or a cylindrical can; however, a chip-type thermistor is used in the present invention, whereby cost reduction is possible.

A protective case 110 may be disposed on the top of the cylindrical battery cell 100. The protective case 110 may have an open bottom, a circular upper surface, and a side surface extending perpendicularly from the upper surface, and the interior of the protective case may be empty.

The protective case 110 is mounted on the top of the cylindrical battery cell 100 so as to cover the PCB 120 and the thermistor 130, and the PCB 120 and the thermistor 130 disposed in an interior space of the protective case 110 may be protected from external impact by the protective case 110.

FIG. 4 is a plan view showing embodiments of a PCB according to the present invention.

Referring to FIG. 4, (a) is a plan view of a PCB 120 according to a first embodiment and a thermistor 130 and a thermally conductive adhesive 140 attached thereto, and (b) is a plan view of a PCB 120 according to a second embodiment and a thermistor 130 and a thermally conductive adhesive 140 attached thereto.

In the first embodiment shown in (a) of FIG. 4, the PCB 120 is configured to have a structure in which one side of a planar circular shape is cut, a protrusion 121 is formed at an outer periphery of the cut side so as to protrude outwards, and a thermistor 130 is located at the protrusion 121.

Although the thermistor 130 is shown as being located at a central part of the protrusion 121 in (a) of FIG. 4, the thermistor 130 may be located at a protruding end of the protrusion 121.

In the first embodiment shown in (a) of FIG. 4, when the thermally conductive adhesive 140 is added so as to completely cover the protrusion 121 and the thermistor 130, the thermally conductive adhesive 140 may be added to even the upper surface of the cylindrical battery cell.

In the second embodiment shown in (b) of FIG. 4, the PCB 120 is configured to have a structure in which a pair of slits 122 parallel to each other is formed in a planar circular shape so as to extend in a direction from an outer periphery to the center thereof and a thermistor 130 is located between the pair of slits 122.

In the second embodiment, when the thermally conductive adhesive 140 is added so as to completely cover the space between the slits 122 of the PCB 120 and the thermistor 130, the thermally conductive adhesive 140 may be added to even the upper surface of the cylindrical battery cell.

The shape of the PCB in the battery cell assembly according to the present invention is not limited to the shape shown in FIG. 4, and the PCB may be configured in various forms depending on the shape and size of a circuit printed on the PCB. For example, the PCB may be configured to have a structure in which a thermistor is located at an outer periphery of one side of a planar polygonal flat PCB.

A method of manufacturing a battery cell assembly according to the present invention may include a step of preparing a cylindrical battery cell and disposing a PCB on the top thereof, a step of connecting a positive electrode terminal and a negative electrode terminal of the cylindrical battery cell to the PCB, a step of mounting a thermistor on an outer periphery of one side of the PCB, and a step of adding a thermally conductive adhesive to the thermistor, the PCB having the thermistor mounted thereon, and an upper surface of the cylindrical battery cell.

When a predetermined amount of thermally conductive adhesive is added to the thermistor mounted on the PCB such that the thermally conductive adhesive contacts even the upper surface of the cylindrical battery cell, the thermistor may indirectly contact the cylindrical battery cell via the thermally conductive adhesive.

In addition, the method may further include a step of mounting a protective case configured to protect the thermistor and the PCB to the top of the cylindrical battery cell.

In the battery cell assembly according to the present invention, the PCB and the thermistor may be protected by the protective case, and heat transfer may be achieved from the cylindrical battery cell to the thermistor via the thermally conductive adhesive, whereby it is possible to accurately measure the temperature of the cylindrical battery cell.

In the battery cell assembly according to the present invention, as described above, the temperature of the cylindrical battery cell may be accurately measured to determine the state of the cylindrical battery cell, and therefore it is possible to effectively exhibit the function of the battery cell assembly according to the present invention when the battery cell assembly is included as an energy source of a device exposed to a high temperature environment.

Hereinafter, the present invention will be described with reference to an example of the present invention; however, the example is provided only for easier understanding of the present invention and should not be construed as limiting the scope of the present invention.

### <Comparative Example>

As in the conventional battery cell assembly shown in FIG. 1, a thermistor configured to measure the temperature of a cylindrical battery cell was disposed at a central part of a PCB on an upper surface of the PCB.

The temperature of the thermistor and the temperature of the cylindrical battery cell were measured while the battery cell assembly was charged and discharged.

As a result, it is possible to obtain the deviation ΔT between the temperature of the thermistor and the temperature of the cylindrical battery cell.

### <Example>

As in the battery cell assembly according to the present invention shown in FIG. 2, a thermistor configured to measure the temperature of a cylindrical battery cell was disposed at an outer periphery of one side of an upper surface of a PCB, and a thermally conductive adhesive was added to the thermistor. Indirect contact between the thermistor and the cylindrical battery cell was achieved via the thermally conductive adhesive.

A silicone adhesive with aluminum powder added was used as the thermally conductive adhesive.

The temperature of the thermistor and the temperature of the cylindrical battery cell were measured while the battery cell assembly was charged and discharged.

As a result, it is possible to obtain the deviation ΔT between the temperature of the thermistor and the temperature of the cylindrical battery cell.

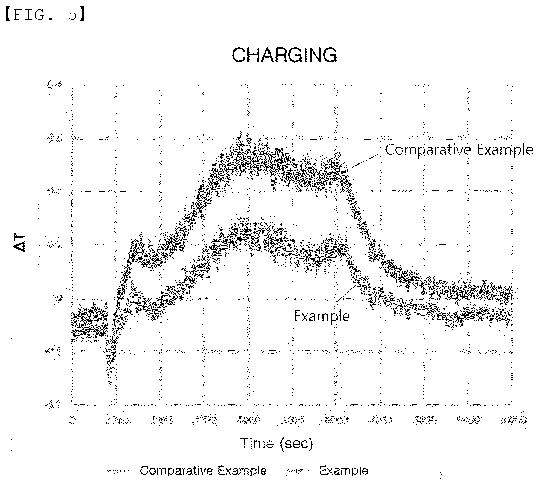

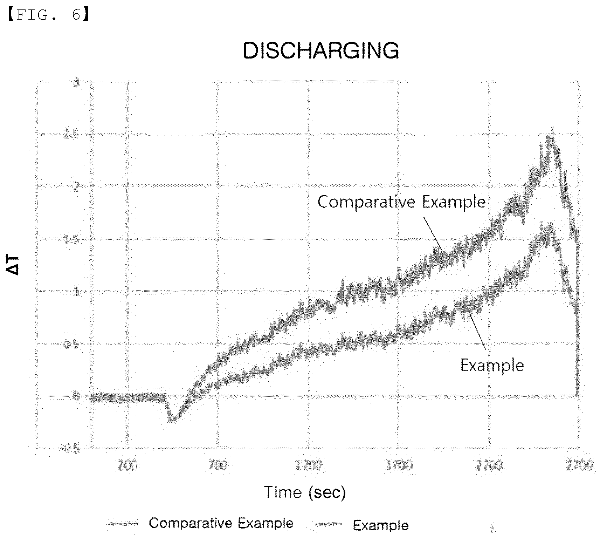

FIG. 5 is a graph showing the deviation ΔT between the temperature of the thermistor and the temperature of the cylindrical battery cell during a charging process in Comparative Example and Example, and FIG. 6 is a graph showing the deviation ΔT between the temperature of the thermistor and the temperature of the cylindrical battery cell during a discharging process in Comparative Example and Example.

Referring to FIGs. 5 and 6, it can be seen that ΔT measured in Comparative Example is greater than ΔT measured in Example in the overall period of the charging process. Consequently, it can be seen that the temperature of the thermistor measured in Comparative Example does not accurately reflect the actual temperature of the cylindrical battery cell.

During the discharging process, ΔT measured in Comparative Example and ΔT measured in Example are almost similar until about 500 seconds, after which ΔT measured in Comparative Example is greater than ΔT measured in Example, and the difference between ΔT values gradually increases over time.

In Comparative Example in which no thermally conductive adhesive is used, the difference between the temperature measured by the thermistor and the actual temperature of the cylindrical battery cell increases over time, and therefore the accuracy of the temperature measured by the thermistor is unreliable.

In contrast, it can be seen that, when the thermistor and the cylindrical battery cell are in indirect contact with each other via the thermally conductive adhesive, as in the present invention, it is possible to relatively accurately measure the temperature of the cylindrical battery cell.

In the present invention, as described above, the position at which the thermistor is disposed is limited to the outer periphery of one side of the upper surface of the PCB, and the thermally conductive adhesive is added so as to be applied to the thermistor and the upper surface of the cylindrical battery cell, whereby it is possible to rapidly and accurately check the temperature of the cylindrical battery cell, and therefore it is possible to provide a battery cell assembly with improved safety.

Those skilled in the art to which the present invention pertains will appreciate that various applications and modifications are possible within the category of the present invention based on the above description.

### (Description of Reference Numerals)

- 100:: Cylindrical battery cell
- 101:: Upper surface of cylindrical battery cell
- 102:: First metal plate
- 103:: Second metal plate
- 110:: Protective case
- 120:: PCB
- 121:: Protrusion
- 122:: Slit
- 130:: Thermistor
- 140:: Thermally conductive adhesive

## Claims

1. A battery cell assembly comprising:
a cylindrical battery cell;
a PCB disposed on a top of the cylindrical battery cell; and
a thermistor configured to measure a temperature of the cylindrical battery cell, wherein
the thermistor is disposed at an outer periphery of one side of the PCB.

2. The battery cell assembly according to claim 1, wherein the PCB comprises a protrusion protruding from the outer periphery of the one side of the PCB, and
wherein the thermistor is disposed on the protrusion.

3. The battery cell assembly according to claim 1, wherein a thermally conductive adhesive is added to the thermistor, the PCB having the thermistor mounted thereon, and an upper surface of the cylindrical battery cell.

4. The battery cell assembly according to claim 3, wherein the thermistor is in indirect contact with the cylindrical battery cell via the thermally conductive adhesive.

5. The battery cell assembly according to claim 3, wherein the thermally conductive adhesive is a mixture of a metal powder and one substance selected from a group consisting of a silicone adhesive, an epoxy adhesive, and an acrylic-based adhesive.

6. The battery cell assembly according to claim 1, further comprising a protective case configured to allow the PCB and the thermistor to be disposed in an interior space of the protective case.

7. The battery cell assembly according to claim 1, further comprising:
a first metal plate configured to connect a positive electrode terminal of the cylindrical battery cell to the PCB; and
a second metal plate configured to connect a negative electrode terminal of the cylindrical battery cell to the PCB.

8. The battery cell assembly according to claim 1, wherein the thermistor is a chip-type thermistor.

9. The battery cell assembly according to claim 1, wherein the PCB is configured to have a structure in which one side of a planar circular shape is cut,
a protrusion is formed at an outer periphery of the cut side so as to protrude outwards from the planar circular shape,
and the thermistor is disposed on the protrusion.

10. The battery cell assembly according to claim 1, wherein the PCB is configured to have a structure in which a pair of slits parallel to each other are formed in a planar circular shape so as to extend in a direction from an outer periphery of the planar circular shape to a center thereof and the thermistor is disposed between the pair of slits.

11. A method of manufacturing the battery cell assembly according to any one of claims 1 to 10, the method comprising:
preparing a cylindrical battery cell and disposing a PCB on a top of the cylindrical battery cell;
connecting a positive electrode terminal and a negative electrode terminal of the cylindrical battery cell to the PCB;
mounting a thermistor on an outer periphery of one side of the PCB; and
adding a thermally conductive adhesive to the thermistor, the PCB having the thermistor mounted thereon, and an upper surface of the cylindrical battery cell.

12. The method according to claim 11, further comprising mounting a protective case configured to protect the thermistor and the PCB to the top of the cylindrical battery cell.

13. A device comprising the battery cell assembly according to any one of claims 1 to 10 as an energy source.
